# EUROPEAN PATENT SPECIFICATION

(11) **EP 2 424 070 B1**
(45) Date of publication and mention of the grant of the patent: **26.10.2016**
(21) Application number: 11178842.8
(22) Date of filing: 25.08.2011
(51) Int. Cl.: H02J 7/00, G01R 31/36, H01M 10/44, H01M 10/48, B60L 11/18, B60L 15/32

(54) **Battery control system and vehicle system with battery control system**
Batteriesteuersystem und Fahrzeugsystem mit dem Batteriesteuersystem
Système de contrôle de batterie et système de véhicule avec système de contrôle de batterie

(30) Priority: 26.08.2010 JP 2010189045
(43) Date of publication of application: 29.02.2012
(73) Proprietor: Hitachi, Ltd., Tokyo 100-8280 (JP)
(72) Inventor: Honda, Mitsutoshi, Chiyoda-ku, Tokyo 100-8220 (JP); Yamauchi, Shuko, Chiyoda-ku, Tokyo 100-8220 (JP); Sasaki, Hironori, Chiyoda-ku, Tokyo 100-8220 (JP); Yamamoto, Tsunenori, Chiyoda-ku, Tokyo 100-8220 (JP)
(74) Representative: Gill, Stephen Charles

(56) References cited:
- EP-A1- 2 093 856
- EP-A2- 1 837 944
- JP-A- 2000 116 014
- JP-A- 2008 153 150
- JP-U- H03 106 845

## Description

### BACKGROUND OF THE INVENTION

### Field of the Invention

The present invention relates to a battery control system with batteries such as secondary batteries mounted therein and a vehicle system with the battery control system mounted therein.

### Description of the Related Art

Secondary batteries have been widely used to deal with environmental problems such as global warming. In a known scheme for cars and rail cars, secondary batteries such as lead batteries, nickel hydrogen batteries, or lithium batteries are mounted. In the scheme, power generated by a regeneration brake is charged in the batteries and utilized for acceleration and the like. This improves fuel efficiency.

In general, the secondary battery increasingly deteriorates as a result of repeated charge and discharge cycles. Two indicators for the deterioration are electric capacity and internal resistance. As the secondary battery increasingly deteriorates, the electric capacity decreases and the internal resistance increases. Extending the life of the secondary batteries is essential for designing such a system as charges, for a long time, a large current generated by the regeneration brake to assist operation during discharge.

A first prior art for extending the secondary battery life is intended to protect the battery by controlling charging and discharging of the battery. In the art, the charge or discharge is stopped depending on the temperature or the voltage of the battery, or a charge current value or a discharge current value is controlled to prevent possible overcharge or over-discharge. This prevents the battery from being deteriorating.

Furthermore, a second prior art is intended to maintain the driving performance of a vehicle as follows (Japanese Patent Laid-Open Publication No. 8-61193 (Patent Document 1)). The battery is characterized in that the maximum usable power of the battery decreases with increasing depth of discharge. Thus, when the maximum usable power becomes equal to power required by the vehicle, the second prior art controllably uses a generator to start charging the battery so as to allow the vehicle to constantly provide the maximum output.

A third prior art is described in Japanese Patent Laid-Open Publication No. 2007-151216 (Patent Document 2). In this method, the power of the battery is limited depending on the charging condition of the battery. Furthermore, Japanese Patent Laid-Open Publication No. 2007-323999 (Patent Document 3) describes a control method for suppressing deterioration of the battery. The method performs deterioration suppression control upon determining that the rate of deterioration of the battery is higher than a reference value.

In these conventional battery control systems, even if the secondary battery includes a plurality of modules, when discharge is required, the modules are generally allowed to discharge an equal amount of current.

As a result, each module has a current waveform indicative of long continuous discharge.

However, in the secondary battery, the long continuous discharge disadvantageously increases the internal resistance to accelerate the deterioration. A cause of the accelerated deterioration is estimated to be that the continuous discharge causes ions to be excessively accumulated between an electrode and an electrolyte, resulting in growth of a less ion-conductive substance on the surface of the electrode.

The simplest method for solving this problem may involve preventing the excessive accumulation of ions by concurrently stopping discharge before completion so as to limit the time for the discharge at most to a predetermined value. However, in the method, the discharge is concurrently stopped, thus reducing the amount of electricity charged and discharged and thus an energy saving effect.

Thus, an object of the present invention is to provide a battery control system with secondary batteries mounted therein which enables as large an amount of charge and discharge to be carried out as possible while allowing each of the batteries to complete a target life, without the need to increase the capacity of the battery.

JP2000116014 proposes a power storing device for compensating for characteristic differences in secondary batteries. JP H03-106845-U is also acknowledged.

### SUMMARY OF THE INVENTION

To accomplish the above-described object, the following technical means are taken for a battery control system according to the present invention. That is, the present invention provides:
(1) a battery control system according to claim 1.
(2) The above-described battery control system further comprises a switch signal adjustment circuit configured to adjust a time required for the circuit breaking sections of the certain number of modules to switch the modules to the circuit breaking state and a time required for the circuit breaking sections of the remaining modules to switch the modules to the energization state.
(3) In the above-described battery control system, during the time required for the circuit breaking sections of the certain number of modules to switch the modules to the circuit breaking state and the time required for the circuit breaking sections of the remaining modules to switch the modules to the energization state, the switch signal adjustment circuit controls the circuit breaking sections so as to keep the amount of discharge constant for both groups of modules.

Moreover, the present invention provides a vehicle according to claim 4, such as a rail car.

Furthermore, in the vehicle, at least two battery control systems described above in (1) to (3) are mounted in such a manner that during discharge, a certain number of the battery control systems are sequentially allowed to halt discharge for a predetermined halt period, while an amount of discharge from remaining battery control systems is increased to complement a decrease in the amount of discharge resulting from the halt of discharge from the certain number of battery control systems.

According to the battery control system according to the present invention, during discharge, the circuit breaking sections of modules are sequentially activated to halt discharge from each of the modules for the predetermined halt time. This prevents possible deterioration of the batteries in the modules. Furthermore, the amount of discharge from the remaining modules is increased to complement the decrease in the amount of discharge resulting from the halt of discharge from the certain number of modules. This eliminates the need to increase the battery capacity.

In this case, the switch signal adjustment circuit configured to adjust the time required for the circuit breaking sections of the certain number of modules to switch the modules to the circuit breaking state and the time required for the circuit breaking sections of the remaining modules to switch the modules to the energization state. Thus, various failures can be prevented which may result from rapid current interruption. Furthermore, during the switching time, a possible variation in the amount of discharge can be prevented by making the amount of discharge constant for both groups of modules.

Additionally, the degree of deterioration of the battery in each module is determined based on the internal resistance of the battery. The halt period for each module is adjusted based on the degree of deterioration. Then, the deterioration can be made equal among the batteries. Hence, the lives of the batteries can be maximized.

Moreover, the halt period for each module is adjusted depending on a difference in temperature between the modules. Thus, the degree of deterioration resulting from a variation in the temperature of the module can be made equal among the batteries.

When the above-described battery system is applied to a vehicle such as a hybrid rail car, possible deterioration of batteries such as lithium ion secondary batteries can be minimized. Hence, the batteries can be used for a long time without reducing the energy saving effect. Furthermore, for a vehicle with a plurality of the battery control systems mounted therein, when the battery control systems are sequentially subjected to the halt period, the need to replace the batteries in each battery control system can be minimized.

### BRIEF DESCRIPTION OF THE DRAWINGS

Figure 1 is a schematic diagram of a battery control system;
Figure 2 is a diagram showing a hybrid rail system to which the battery control system is applied;
Figure 3 is a schematic diagram of a circuit breaking arrangement;
Figure 4 is a schematic diagram of a switching waveform;
Figure 5 is a diagram showing a traveling pattern of a hybrid rail car;
Figure 6 is a diagram showing a current pattern for discharge;
Figure 7 is a diagram showing a current pattern obtained when an equal current flows from each module;
Figure 8 is a current pattern obtained when halts of discharge are set for each module;
Figure 9 is a diagram illustrating the relationship between the number of cycles and deterioration;
Figure 10 is a diagram showing current waveforms obtained when a discharge current pattern is varied;
Figure 11 is a diagram showing a hybrid rail system with a battery control system provided in each of a leading car and a trailing car;
Figure 12 is a diagram illustrating outputs of discharge halt commands and discharge resumption commands; and
Figure 13 is a diagram showing charge and discharge patterns of driving apparatuses A and B provided in a hybrid rail system.

### DETAILED DESCRIPTION OF THE PREFERRED EMBODIMENTS

Embodiments of the present invention will be described below with reference to the drawings. In the embodiments described below, by way of example, the present invention is applied to a battery control system forming a power supply for a hybrid rail car. Embodiments

### (Embodiment 1)

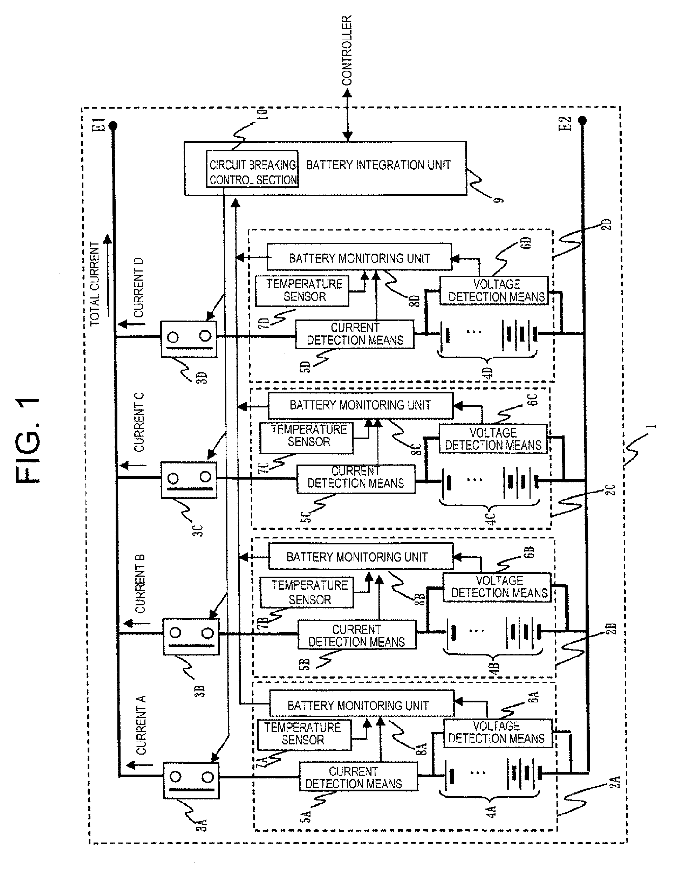

Figure 1 shows an example of a configuration of a battery control system according to the present invention.

A battery control system 1 includes battery modules 2A to 2D, circuit breakers 3A to 3D configured to freely switch between an energization state and a circuit breaking state, and a battery integration unit 9 configured to control the whole control system.

Moreover, the battery modules 2A to 2D include assembled batteries 4A to 4D each including a plurality of cells, current detection means 5A to 5D for detecting current flowing through the corresponding assembled battery, voltage detection means 6A to 6D for detecting the assembled voltage of the corresponding assembled battery, temperature sensors 7A to 7D each configured to measure the temperature in the corresponding module, and battery monitoring units 8A to 8D each configured to monitor each battery. Inverters or the like are connected to E1 and E2.

Each of the assembled batteries 4A to 4D is a unit in which a plurality of batteries capable of accumulating and releasing electric energy, for example, nickel hydrogen batteries and lithium-ion secondary batteries, are connected together in series. In the description of the present embodiment, lithium-ion secondary batteries are adopted.

In the description of the present embodiment, the assembled batteries 4A to 4D are connected together in parallel. However, this is not intended to limit the number of parallel assembled batteries to which the present embodiment is applicable, to four. Even if a different number of assembled batteries are connected together in parallel, the present invention can be implemented by adopting technical means similar to those in the present embodiment.

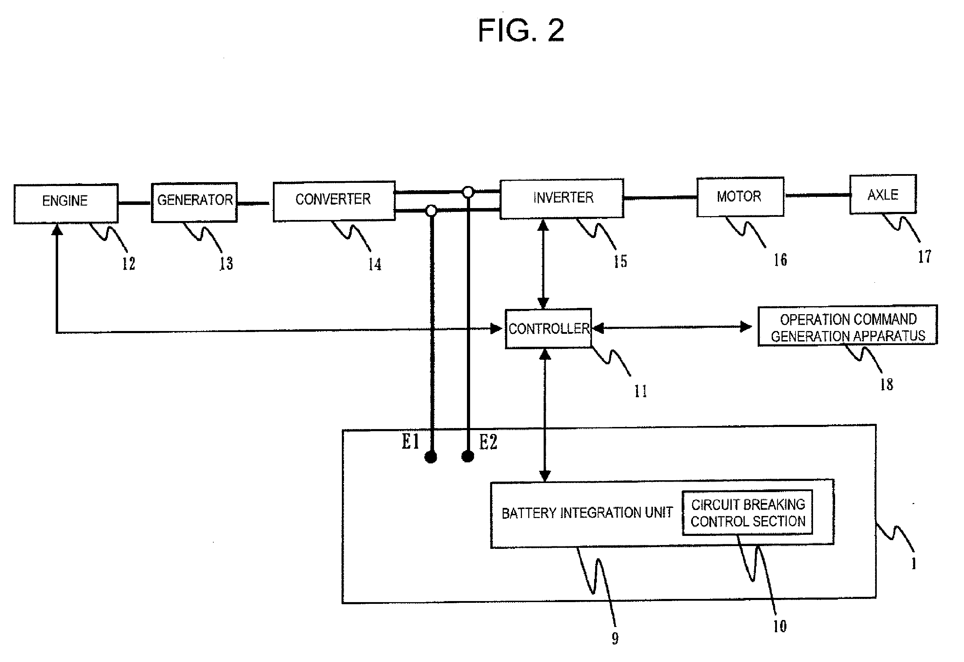

The present embodiment is based on the assumption that the battery control system 1 is a storage apparatus for hybrid rail car. Thus, for description, in Figure 2, the battery control system according to the present embodiment is applied to a hybrid rail car.

The present embodiment adopted a series hybrid scheme. An engine 12 drives a generator 13 to generate power, which is supplied to a motor 16 via a converter 14 and an inverter 15. That is, the battery control system 1 supplies power to the inverter 15. The motor 16 uses the power obtained from the engine 12 and the power obtained from the battery control system 1 to transmit a driving force to an axle 17. In Figure 2, the battery control system includes only a battery integration unit 9, a circuit breaking control section 10, and connections E1 and E2. However, the interior of the battery control system is the same as that shown in Figure 1.

During deceleration, in response to rotation of the axle 17, the motor 16 operates as a generator 13 to convert (regenerate) kinetic energy into electric energy to charge the assembled batteries 4A to 4D of the battery control system 1 via the inverter 15. A controller 11 controls the power supply from the engine 12, the acceleration and regeneration of the motor 16, and the power supply from the battery control system 1 based on operation commands issued by an operation command generation apparatus 18. If the battery control system can supply power for lighting and air conditioning in the rail car, a control apparatus (not shown) for the lighting and air conditioning is also included in the controller 11.

The present embodiment will be further described with reference again to Figure 1. In the present embodiment, the system includes the circuit breakers 3A to 3D, the current detection means 5A to 5D, the voltage detection means 6A to 6D, the temperature sensors 7A to 7D, and the battery monitoring units 8A to 8D. These components will be described below.

The circuit breakers 3A to 3D are apparatuses connected in series with the respective assembled batteries 4A to 4D to freely switch between the energization state and the circuit breaking state. Control signals are transmitted by a circuit breaking controller mounted in the battery integration unit. When the circuit breaker is switched to the circuit breaking state, the corresponding one of the assembled batteries 4A to 4D is electrically disconnected. That is, the assembled batteries 4A to 4D are prevented from undergoing charge and discharge in accordance with signals from the circuit breaking control section 10. When the circuit breakers 3A to 3D are switched back to the energization state, the assembled batteries 4A to 4D are enabled again to undergo charge and discharge. The circuit breakers 3A to 3D may be semiconductor switches or mechanical switches provided that the switch apparatuses provide the above-described functions and can deal with the maximum value of a current to be interrupted. The switching method will be described below in detail in conjunction with the circuit breaking control section.

In the present embodiment, to monitor the states of the assembled batteries 4A to 4D, the system includes the current detection means 5A to 5D serving as current detection sections, the voltage detection means 6A to 6D serving as voltage detection sections, and temperature sensors 7A to 7D each configured to measure the temperature in the corresponding module. Each of the current detection means 5A to 5D is connected between the corresponding one of the assembled batteries 4A to 4D and the corresponding one of the circuit breakers 3A to 3D to measure the amount of current discharged from or charged into the corresponding one of the assembled batteries 4A to 4D. As accurate current sensors as possible are desirably used as the current detection means 5A to 5D to allow the battery monitoring units 8A to 8D to accurately determine the state of charge (hereinafter referred to as the SOC (State of Charge)).

For example, it is assumed that the assembled batteries 4A to 4D provide a voltage of 1,500 V as is the case with an AC section of a general rail car and are used to move two motors with a rated power of about 150 kW. Then, the current control system 1 discharges a current of about 200 A. Thus, the required current is estimated to be about 200 A. In this case, a common Hall CT or shunt resistance current sensor may be used.

The voltage detection means measures a voltage applied to the batteries. As is the case with the current, the voltage detection means may be a voltage sensor with an appropriate rated voltage for the assembled batteries 4A to 4D within the range in which the SOC can be accurately determined. As described above, the appropriate voltage sensor has a rated voltage of about 1,500 V. The temperature sensor is installed at an appropriate location in the module to measure the temperature inside the module. A thermistor is normally used as the temperature sensor.

The battery monitoring units 8A to 8D are apparatuses configured to monitor the condition of the battery (including functional diagnosis and occurrence of abnormality) based on measured values (current values and voltage values) from the current detection means 5A to 5D and the voltage detection means 6A to 6D. Information such as the current values and voltage values obtained is transmitted to the battery integration unit 9.

The battery integration unit 9 determines the condition of the battery control system 1. To achieve this, the battery integration unit 9 acquires and processes battery information acquired and calculated by the battery monitoring units 8A to 8D. Based on the acquisition and processing of the information, the battery integration unit 9 transmits charge and discharge control information indicating, for example, whether or not to continue charging or discharging the battery, to the controller 11. The battery integration unit 9 then receives a charge and discharge commands from the controller 11. Moreover, as described below, the circuit breaking control section 10 is mounted inside the battery integration unit 9 to control the circuit breakers 3A to 3D based on the battery information acquired and processed by the battery monitoring units 8A to 8D.

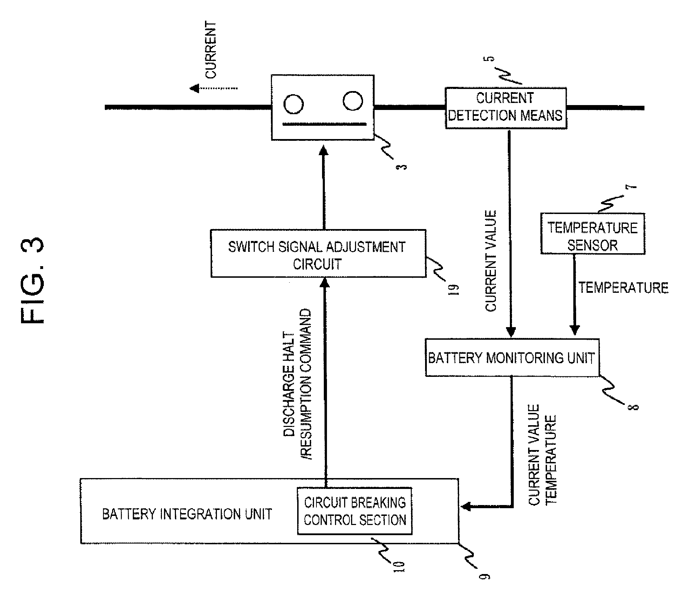

As shown in Figure 3, the information such as the current value obtained by the current detection means 5 and the temperature in the module obtained by the temperature sensor 7 is transmitted to the circuit breaking control section 10 in the battery integration unit 9 via the battery monitoring units 8A to 8D. The circuit breaking control section 10 transmits a signal for suspension or resumption of discharge to the circuit breakers 3A to 3D based on pre-incorporated information and the information including the current value and the temperature obtained from the battery monitoring units 8A to 8D.

At this time, the switch signal adjustment circuit 19 adjusts the length of a switching shift time to an appropriate value so that the circuit breakers 3A to 3D are switched from an off state (discharge disabled) to an on state (discharge enabled) or from the on state to the off state with a predetermined delay time. This prevents various failures resulting from rapid current interruption.

The process in which the circuit breaking controller outputs a signal to switch the on/off state of the current will be specifically described.

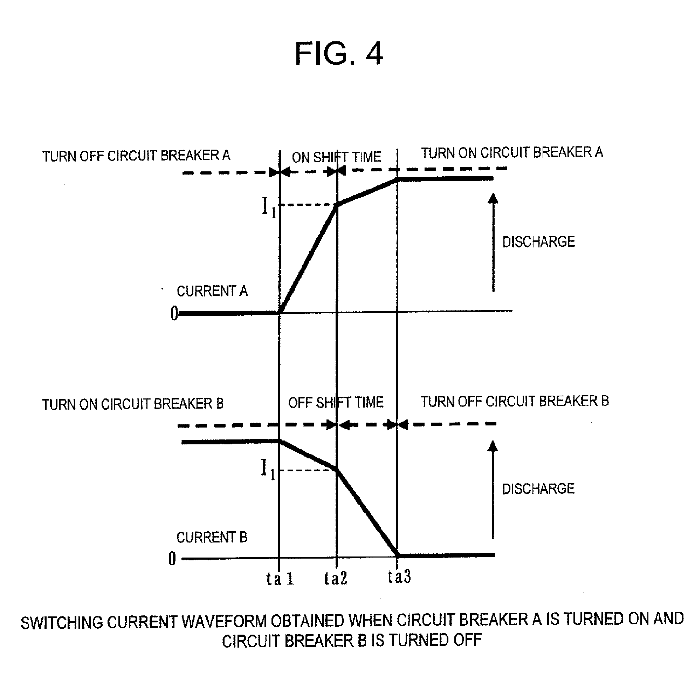

In the description, by way of example, the circuit breaker 3A in the off state, which is connected to the module 2A, is switched on, and the circuit breaker 3B in the on state, which is connected to the module 2B, is switched off. Figure 4 is a detailed diagram.

At a point of time ta1, a signal for turning on the circuit breaker is inputted to the circuit breaker 3A. Then, the module 2A starts discharging, and the amount of discharge gradually increases. At the same time, a current through the module 2B starts to decrease as a result of turnoff of the circuit breaker 3B. Then, predetermined switching shift time (sift-to-on time) elapses, and at a point of time ta2, a current through the module 2A becomes almost equivalent to the current through the module 2B (as shown by I1 in Figure 4).

This condition is detected by the current detection means 5 and transmitted to the circuit breaking control section 10. Then, the circuit breaking control section 10 transmits a signal for suspending the discharge to the circuit breaker 3B. Furthermore, a signal for increasing the amount of discharge is inputted to the circuit breaker 3A. A signal for stopping the discharge is inputted to the circuit breaker 3B. Thus, a current A increases, while a current B decreases. Then, an off shift period elapses. At a point of time ta3, the amount of discharge from the module 2A reaches the maximum value, while the amount of discharge from the module 2B becomes almost zero.

As described above, when the module 2A with discharge halted resumes discharging and the discharging module 2B is set to the discharge halted state, the switching shift time set for the circuit breakers 3A and 3B serves to keep the total amount of discharge from both modules 2A and 2B at a value obtained when only the module 2A or 2B discharges (a period until ta1 or a period starting at ta3). Thus, smooth switching can be achieved without significantly varying the amount of discharge.

The life of the batteries in the battery control system 1 set as described above will be discussed. The degree of deterioration, which is indicative of the life, is determined on the battery monitoring units 8A to 8D based on the current values transmitted by the current detection means 5A to 5D, the voltage values transmitted by the voltage detection means 6A to 6D, and the temperature information detected by the temperature sensor. The state of deterioration is generally defined by the rate of increase in internal resistance or the rate of the capacity maintained. However, the degree of deterioration is often estimated based on the internal resistance, which is easy to measure. The present embodiment also adopted the rate of increase in internal resistance. The rate of increase in internal resistance was defined as an internal resistance value divided by an initial resistance value multiplied by 100. A higher degree of deterioration is indicative of a higher rate of increase in internal resistance.

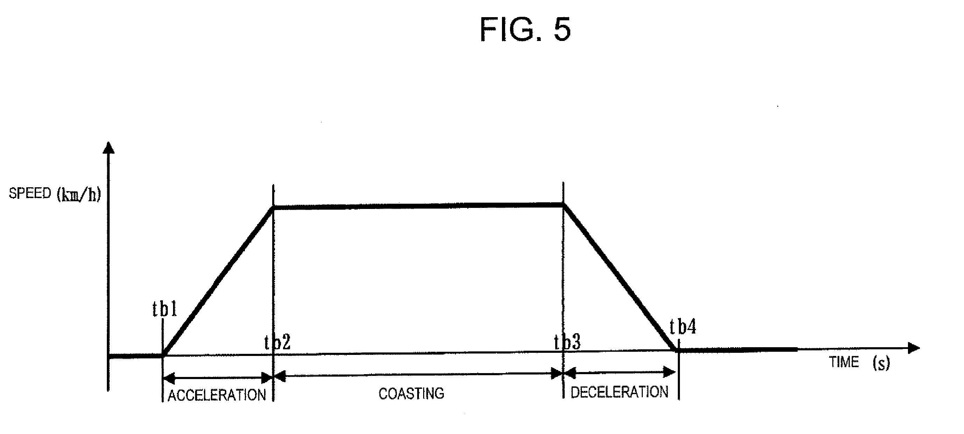

Figure 5 shows an example of a traveling pattern of a hybrid rail car according to the present embodiment.

The rail car travels in a typical traveling pattern as follows. First, the rail car departs from the current station at a point of time tb1, and accelerates until a point of time tb2. The rail car then reaches a predetermined speed and coasts between the point of time tb2 and a point of time tb3 utilizing the enormous inertia mass of the rail car and the low coefficient of rolling friction of the railway. Thereafter, at the point of time tb3, the rail car decelerates by actuating a regeneration brake. At a point of time tb4, the rail car stops at the next station. In the meantime, the above-described traveling pattern is maintained regardless of the performance of the assembled batteries 4A to 4D.

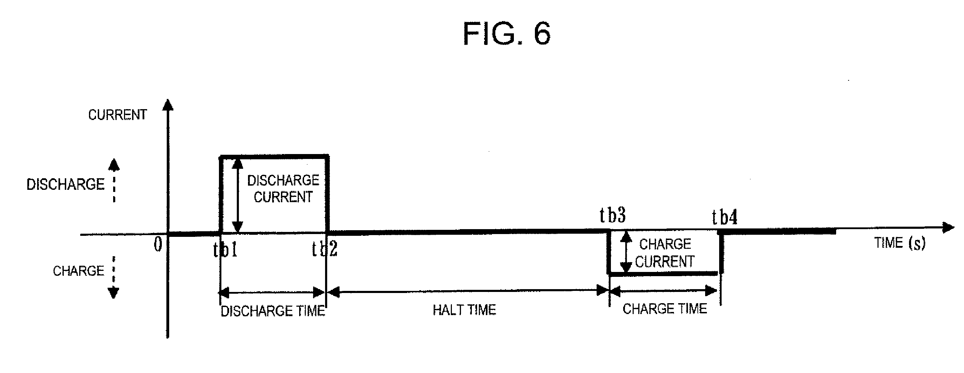

Based on the traveling pattern and power characteristics such as the engine, a current pattern for discharge required for the assembled batteries 4A to 4D in the respective modules was specified as shown in Figure 6. That is, during the acceleration between the point of time tb1 and the point of time tb2, the assembled batteries discharge at a given discharge current for a given time. Then, the assembled batteries halt discharge during the coasting. Then, a charging process is carried out as a result of regeneration during the deceleration. The traveling pattern corresponds to one cycle, and the life is determined based on a variation in the degree of deterioration with respect to the number of cycles.

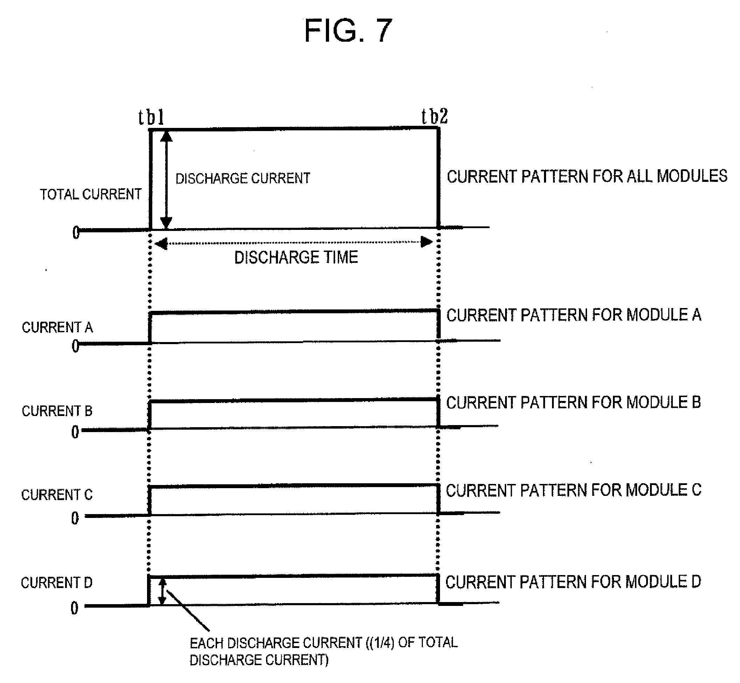

To verify the effects of the present invention, first, the rail car is allowed to travel with the assembled batteries controlled according to a conventional method. The conventional method corresponds to the present method in which the circuit breakers 3A to 3D shown in Figure 1 are not mounted and in which an equal current flows from the assembled battery in each module as shown in Figure 7.

The current pattern shown in Figure 6 indicates that the discharge current pattern corresponds to the sum of currents discharged from the assembled batteries in all the modules, which sum is shown in Figure 7, and that an equal current is discharged from the four modules A to D.

Then, the present invention is applied to the traveling, with halts interposed during discharge. In this example, for instance, when the acceleration period between the point of time tb1 and the point of time tb2 is 1 minute, the halt period is set to take place every 5 seconds for each of the modules A to D in this order. For each module, a 5-second halt period and a 15-second discharge period are repeated.

Even in this case, the following operation is performed to keep the sum of currents discharged from all the modules constant. For the three modules corresponding to all the modules except the one in the halt state, the amount of discharge is increased by one-third compared to that according to the conventional method. This serves to complement a decrease in the amount of discharge resulting from the halt of discharge from the one module.

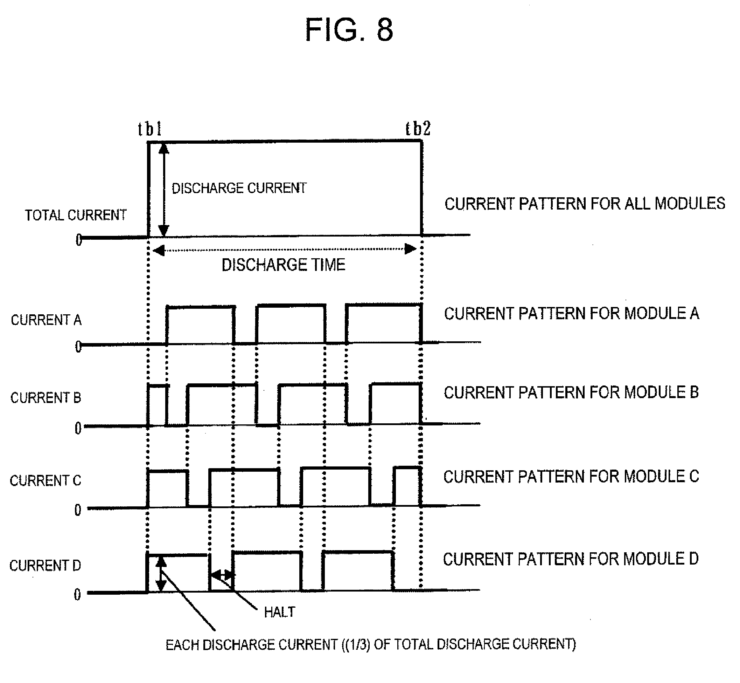

Figure 8 shows a variation in discharge current. Figure 8 shows that halts are interposed during discharge for the modules A to D in this order. The amount of discharge from each module is normally limited to a relatively small value with respect to the capacity of the secondary battery so as to prevent instantaneous deterioration of the secondary battery resulting from overcharge. Thus, the amount of discharge can be increased by about one-third without any problem. Figure 8 indicates that the 5-second halt period following every 15-second discharge effectively suppresses deterioration of each module.

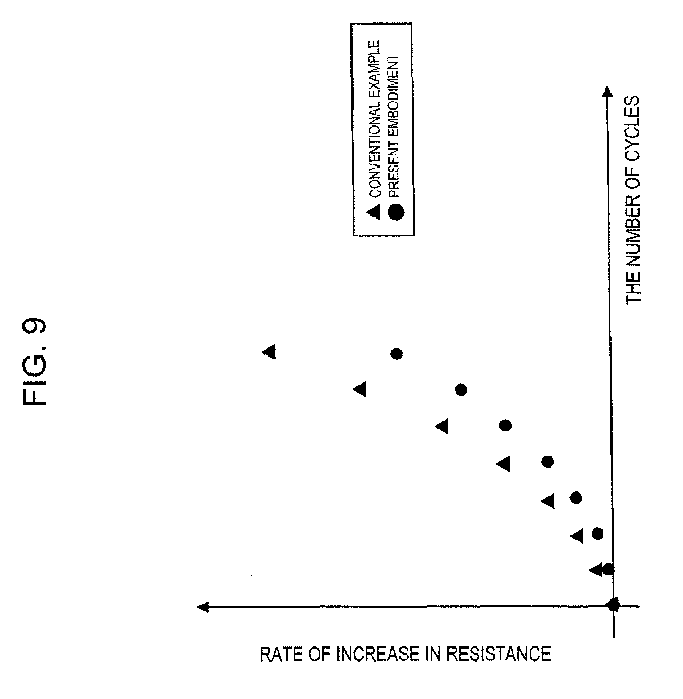

Figure 9 is a diagram showing variations in the degree of deterioration according to the conventional method and the method of the present embodiment. In Figure 9, the axis of abscissa indicates the number of cycles. The axis of ordinate indicates the rate of increase in resistance, which corresponds to the degree of deterioration. As is apparent from Figure 9, compared to the conventional example (plotted with black filled-in circles), the present embodiment (plotted with black filled-in triangles) effectively reduces the degree of deterioration with increasing number of cycles. The results in Figure 9 indicate that halts interposed during discharge serve to suppress deterioration to extend the battery life.

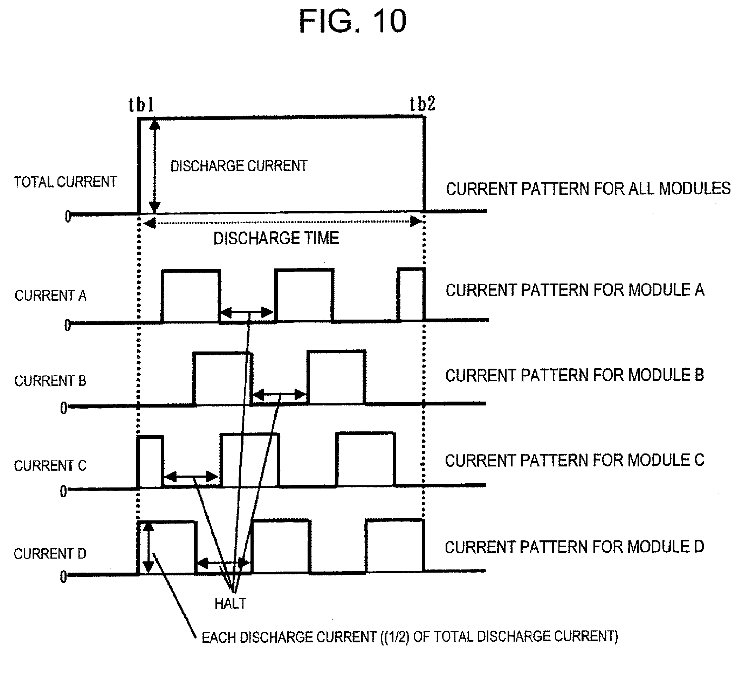

In the above-described example, the current from one module is interrupted to halt discharge. However, simultaneous halt periods can be set for two modules. Figure 10 shows an example of current waveforms obtained when simultaneous halt periods are set for two modules. In this case, the halted modules are switched every 5 seconds in the following order: A and B, B and C, C and D, and D and A. In this case, the modules subjected to discharge provide twice as large an amount of discharge as that according to the conventional method illustrated in Figure 6. However, the halt period achieved is almost the same as the discharge period achieved. Thus, the results shown in Figure 10 indicate that this technique allows deterioration to be effectively suppressed as in the case where halts are set for one module. The technique thus allows the battery life to be extended.

### (Embodiment 2)

In the present embodiment, a manner of setting halts will be described which is carried out taking into account the degree of deterioration of each of the assembled batteries 4A to 4D in the battery modules 2A to 2D forming the battery control system 1. The degree of deterioration may be unbalanced by differences among individual batteries, differences in the magnitude of a flowing current among the modules, or the like. Moreover, the unbalance may be caused by replacement of only some of the batteries with new ones resulting from a failure or the like.

As is known, when modules with the degree of deterioration varying among the assembled batteries 4A to 4D thereof are subjected to charge and discharge, the life of the assembled batteries 4A to 4D can be eventually extended by carrying out the charge and discharge so as to make the degree of deterioration equal among the batteries.

An indicator used for the degree of deterioration is the rate of increase in resistance defined based on the internal resistance value as is the case with Embodiment 1. To calculate the halt period for each module, as a new indicator, a relative degree of deterioration, is introduced. The relative degree of deterioration is calculated by dividing the degree of deterioration of each module by the average value of the degrees of deterioration of the modules.

That is, for example, if the module A has a degree of deterioration of 120 and the other three modules have a degree of deterioration of 100, the average value is (100 x 3 + 120) / 4 = 105. Thus, the relative degree of deterioration of the module A is determined to be (8/7) by dividing the degree of deterioration (120) of the module A by the average value (105). Moreover, the halt time for each module is calculated by multiplying the normal halt time by the relative degree of deterioration of the module. When the normal halt time is set to 20 seconds, the halt time for the module A is 20 x (8/7).

This setting allows a longer halt period to be set for a module with a higher degree of deterioration, while allowing a shorter halt period to be set for a module with a lower degree of deterioration. Thus, the degree of deterioration can be made equal among the modules, eventually allowing the deterioration to be made equal among the batteries. As a result, the battery life can be maximized.

If the temperature varies among the modules, the modules may be restrained from deteriorating increasingly as follows. As is the case with the present embodiment, a conversion factor is determined, and the halt time for each module is adjusted by being multiplied by the conversion factor.

### (Embodiment 3)

In the present embodiment, a case will be described where a plurality of battery control systems each with a plurality of modules are provided and where halts are set for the battery control systems. By way of example, one battery control system is provided in each of the leading and trailing hybrid rail cars.

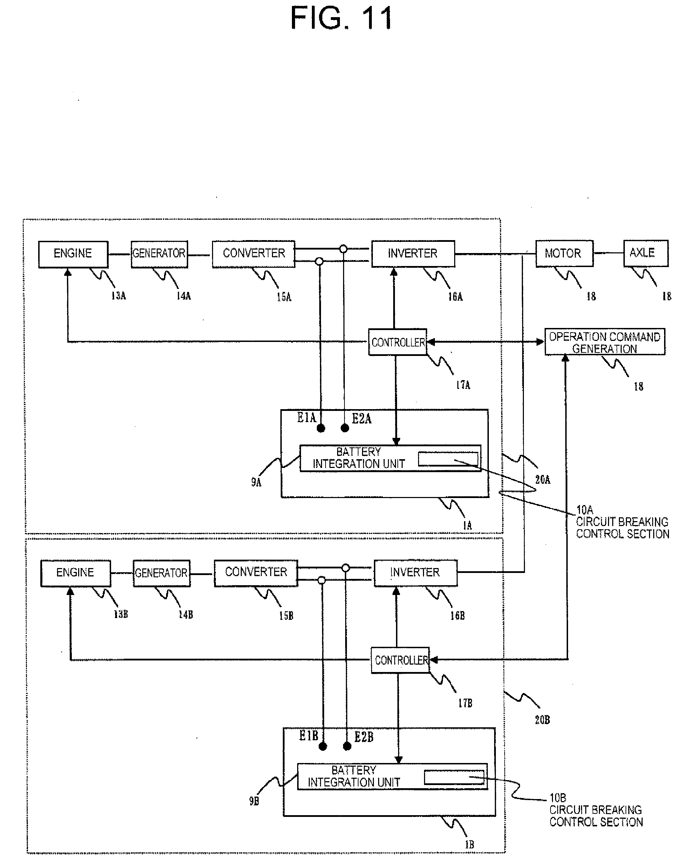

Figure 11 shows the corresponding system. A driving system A in the leading car is shown at 20A. A driving system B in the trailing car is shown at 20B. Each of the driving systems includes an engine 13, a generator 14, a converter 15, an inverter 16, a controller 17, and a battery control system 18 with a plurality of modules. Each driving system transmits power obtained from the engine and the battery control system to the motor to drive the axle. Furthermore, during deceleration, each driving system utilizes regeneration to allow the motor to charge the assembled batteries in the battery control system in each driving system.

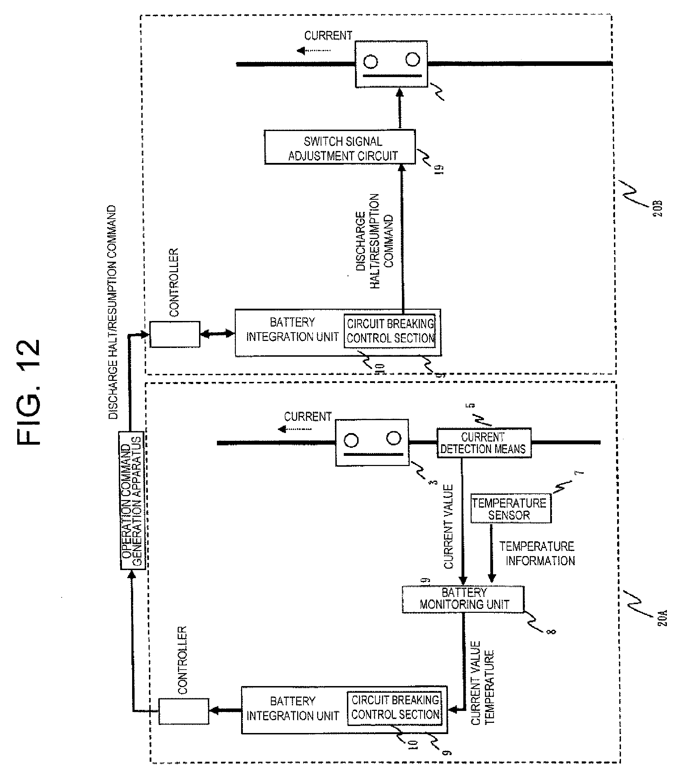

An operation command generation apparatus transmits various commands including ones for charge and discharge to the controller in each driving system. Figure 12 illustrates only discharge halt commands and discharge resumption commands based on current and temperature information on the driving system A.

A current value and temperature information collected in a battery integration unit are transmitted to the operation command generation apparatus via the controller. Based on the information, the operation command generation apparatus determines whether to resume or halt discharge. The driving command generation apparatus then transmits the corresponding command to the circuit breaker via the controller and the circuit breaking control section. A difference from the embodiment illustrated in Figure 3 is that the operation command generation apparatus outputs a discharge halt command to the battery integration unit in one of the driving systems and a discharge resumption command to the battery integration unit in the other driving system.

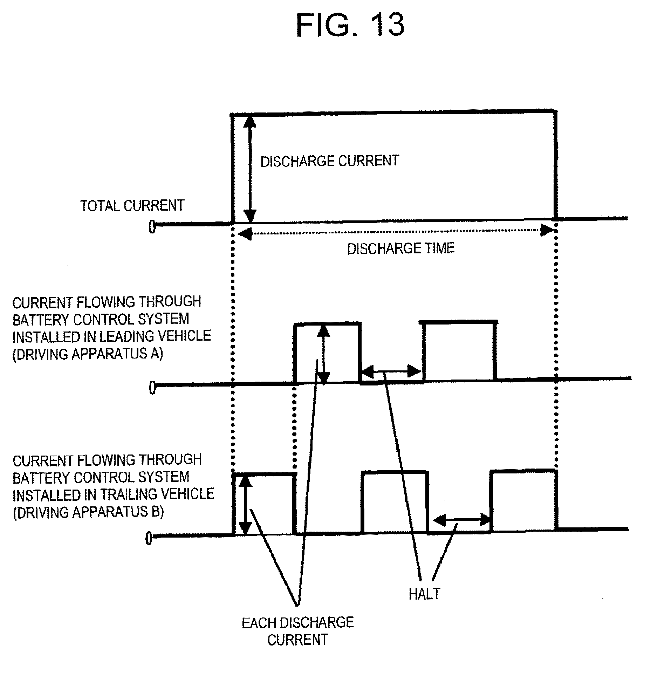

Figure 13 shows charge and discharge patterns for the driving apparatuses A and B. In this example, when a discharge halt command is outputted to the driving apparatus A, a discharge resumption command is outputted to the driving apparatus B. When the discharge resumption command is outputted to the driving apparatus A, the discharge halt command is outputted to the driving apparatus B. A total discharge current pattern for the driving apparatuses A and B is the same as the pattern in Figure 6. As is apparent from Figure 13, halt periods are set for each of the driving apparatuses A and B. Also in this embodiment, when the degree of deterioration is measured for the assembled batteries in each of the driving apparatuses A and B, the measurement results indicated that setting of discharge halts allows deterioration to be suppressed.

Of course, discharge halt periods according to Embodiment 1 or 2 described above may be set for the plurality of modules provided in the battery control system in each of the driving apparatuses A and B so that the halt period can be comprehensively controlled for all the modules.

## Claims

1. A battery control system (1) comprising battery modules (2A-D) connected together in parallel, each of the battery modules comprising an assembly battery (4A-D) and a battery monitoring unit (8A-D) comprising current detection means (5A-D) and voltage detection means (6A-D) and a temperature sensor (7A-D) for the assembly battery,
each battery module comprises a circuit breaking section (3A-D) configured to control an energization state and a circuit breaking state of the assembly battery **characterized in that**
during discharge, the circuit breaking sections of a certain number of battery modules are sequentially activated to halt discharge from each of the certain number of battery modules for a predetermined halt time, while an amount of discharge from remaining battery modules is increased to complement a decrease in the amount of discharge resulting from the halt of discharge from the certain number of battery modules; and
the battery control system comprises deterioration determination means for calculating an internal resistance of the assembly battery in each of the battery modules based on detected values from the current detection means and the voltage detection means and generating a relative degree of deterioration by comparing the internal resistance with a reference internal resistance value,
wherein a halt period for each of the battery modules is adjusted based on the relative degree of deterioration of each battery module calculated by the deterioration determination means, such that the halt period of the battery module with higher relative degree of deterioration becomes longer, and the halt period of the battery module with lower relative degree of deterioration becomes shorter.

2. The battery control system according to claim 1, further comprising a switch signal adjustment circuit (19) configured to adjust a time required for the circuit breaking sections of the certain number of battery modules to switch the battery modules to the circuit breaking state and a time required for the circuit breaking sections of the remaining battery modules to switch the battery modules to the energization state.

3. The battery control system according to claim 2, wherein during the time required for the circuit breaking sections of the certain number of battery modules to switch the battery modules to the circuit breaking state and the time required for the circuit breaking sections of the remaining battery modules to switch the battery modules to the energization state, the switch signal adjustment circuit controls the circuit breaking sections so as to keep the amount of discharge constant for both groups of battery modules.

4. A vehicle comprising a battery control system according to claims 1 to 3 mounted therein.

5. The vehicle according to claim 4, wherein the vehicle comprises a plurality of the battery control systems mounted therein in such a manner that during discharge, a certain number of the battery control systems are sequentially allowed to halt discharge for a predetermined halt period, while an amount of discharge from remaining battery control systems is increased to complement a decrease in the amount of discharge resulting from the halt of discharge from the certain number of battery control systems.

## Patentansprüche

1. Batteriesteuersystem (1) mit Batteriemodulen (2A-D), die parallel miteinander verbunden sind und jeweils eine Einbaubatterie (4A-D) und eine Batterieüberwachungseinheit (8A-D) umfassen, die eine Stromerfassungseinrichtung (5A-D) und eine Spannungserfassungseinrichtung (6A-D) sowie einen Temperatursensor (7A-D) für die Einbaubatterie aufweist,
wobei jedes Batteriemodul einen Schaltunterbrechungsabschnitt (3A-D) umfasst, der zum Steuern eines Energiespeisungszustands und eines Schaltunterbrechungszusands der Einbaubatterie eingerichtet ist,
**dadurch gekennzeichnet, dass**
während eines Entladens die Schaltunterbrechungsabschnitte einer gewissen Anzahl an Batteriemodulen nacheinander aktiviert werden, um ein Entladen aus jedem der gewissen Anzahl an Batteriemodulen für eine vorbestimmte Haltezeit anzuhalten, während eine Entlademenge aus übrigen Batteriemodulen erhöht wird, um eine Ergänzung für eine Abnahme der Entlademenge zu schaffen, die aus dem Anhalten der Entladung aus der gewissen Anzahl an Batteriemodulen folgt; und
das Batteriesteuersystem eine Verschlechterungsbestimmungseinrichtung umfasst, um aufgrund von erfassten Werten aus der Stromerfassungseinrichtung und der Spannungserfassungseinrichtung einen Innenwiderstand der Einbaubatterie in jedem der Batteriemodule zu berechnen und durch Vergleichen des Innenwiderstands mit einem Innenwiderstandsbezugswert einen relativen Verschlechterungsgrad zu erzeugen,
wobei aufgrund des relativen Verschlechterungsgrads jedes Batteriemoduls, der von der Verschlechterungsbestimmungseinrichtung berechnet wird, eine Halteperiode für jedes der Batteriemodule so eingestellt wird, dass die Halteperiode des Batteriemoduls mit höherem relativem Verschlechterungsgrad länger wird und die Halteperiode des Batteriemoduls mit niedrigerem relativem Verschlechterungsgrad kürzer wird.

2. Batteriesteuersystem nach Anspruch 1 mit einer Schaltsignal-Einstellschaltung (19), die zum Einstellen einer Zeit, die für die Schaltunterbrechungsabschnitte der gewissen Anzahl an Batteriemodulen benötigt wird, um die Batteriemodule in den Schaltunterbrechungszustand zu schalten, sowie einer Zeit, die für die Schaltunterbrechungsabschnitte der übrigen Batteriemodule benötigt wird, um die Batteriemodule in den Energiespeisungszustand zu schalten, eingerichtet ist.

3. Batteriesteuersystem nach Anspruch 2, wobei während der Zeit, die für die Schaltunterbrechungsabschnitte der gewissen Anzahl an Batteriemodulen benötigt wird, um die Batteriemodule in den Schaltunterbrechungszustand zu schalten, und der Zeit, die für die Schaltunterbrechungsabschnitte der übrigen Batteriemodule benötigt wird, um die Batteriemodule in den Energiespeisungszustand zu schalten, die Schaltsignal-Einstellschaltung die Schaltunterbrechungsabschnitte so steuert, dass die Entlademenge für beide Gruppen an Batteriemodulen konstant gehalten wird.

4. Fahrzeug mit einem darin verbauten Batteriesteuersystem nach einem der Ansprüche 1 bis 3.

5. Fahrzeug nach Anspruch 4, das mehrere der Batteriesteuersysteme umfasst, die darin so verbaut sind, dass während eines Entladens eine gewisse Anzahl der Batteriesteuersysteme nacheinander das Entladen für eine vorbestimmte Haltezeitspanne anhalten dürfen, während eine Entlademenge aus übrigen Batteriesteuersystemen erhöht wird, um eine Ergänzung für eine Abnahme der Entlademenge zu schaffen, die aus dem Anhalten der Entladung aus der gewissen Anzahl an Batteriesteuersystemen folgt.

## Revendications

1. Système de commande de batterie (1) comportant des modules de batterie (2A à 2D) raccordés ensemble en parallèle, chacun des modules de batterie comportant une batterie assemblée (4A à 4D) et une unité de surveillance de batterie (8A à 8D) comportant des moyens de détection de courant (5A à 5D) et des moyens de détection de tension (6A à 6D) et un capteur de température (7A à 7D) pour la batterie assemblée,
chaque module de batterie comporte une partie de coupure de circuit (3A à 3D) configurée pour commander un état de mise sous tension et un état de coupure de circuit de la batterie assemblée, **caractérisé en ce que** pendant la décharge, les parties de coupure de circuit d'un nombre déterminé de modules de batterie sont activées séquentiellement pour arrêter la décharge à partir de chaque module du nombre déterminé de modules de batterie pendant une durée d'arrêt prédéterminée, lorsqu'une quantité de décharge des modules de batterie restants est augmentée pour compléter une baisse de la quantité de décharge résultant de l'arrêt de la décharge du nombre déterminé de modules de batterie, et
le système de commande de batterie comporte des moyens de détermination de détérioration pour calculer une résistance interne de la batterie assemblée dans chacun des modules de batterie sur la base de valeurs détectées à partir des moyens de détection de courant et des moyens de détection de tension et générer un degré relatif de détérioration en comparant la résistance interne à une valeur de résistance interne de référence,
dans lequel une période d'arrêt pour chacun des modules de batterie est réglée sur la base du degré relatif de détérioration de chaque module de batterie calculé par les moyens de détermination de détérioration, de telle sorte que la période d'arrêt du module de batterie ayant le plus grand degré relatif de détérioration devienne plus longue, et la période d'arrêt du module de batterie ayant le plus petit degré relatif devienne plus courte.

2. Système de commande de batterie selon la revendication 1, comportant en outre un circuit de réglage de signal de commutation (19) configuré pour régler un temps requis pour que les parties de coupure de circuit du nombre déterminé de modules de batterie basculent les modules de batterie sur l'état de coupure du circuit, et un temps requis pour que les parties de coupure de circuit des modules de batterie restants basculent les modules de batterie sur l'état de mise sous tension.

3. Système de commande de batterie selon la revendication 2, dans lequel pendant le temps requis pour que les parties de coupure de circuit du nombre déterminé de modules de batterie basculent les modules de batterie sur l'état de coupure de circuit et le temps requis pour que les parties de coupure de circuit des modules de batterie restants basculent les modules de batterie sur l'état de mise sous tension, le circuit de réglage de signal de commutation commande les parties de coupure de circuit de manière à maintenir la quantité de décharge constante pour les deux groupes de modules de batterie.

4. Véhicule comportant un système de commande de batterie selon les revendications 1 à 3 monté dans celui-ci.

5. Véhicule selon la revendication 4, dans lequel le véhicule comporte une pluralité des systèmes de commande de batterie montés dans celui-ci d'une manière telle que pendant une décharge, un nombre déterminé des systèmes de commande de batterie peuvent séquentiellement arrêter la décharge pendant une période d'arrêt prédéterminée, lorsqu'une quantité de décharge des systèmes de commande de batterie restants est augmentée pour compléter une baisse de la quantité de décharge résultant de l'arrêt de la décharge du nombre déterminé de systèmes de commande de batterie.
